# EUROPEAN PATENT APPLICATION

(11) **EP 4 797 890 A1**
(43) Date of publication of application: **26.08.2026**
(21) Application number: 26159297.6
(22) Date of filing: 18.02.2026
(51) Int. Cl.: H05K 7/14

(54) **OUTPUT PCB BUSBAR**

(30) Priority: 19.02.2025 US 202563760434 P; 09.02.2026 US 202619533951
(71) Applicant: Vertiv Corporation, Westerville, OH 43082 (US)
(72) Inventor: STRUBLE-LARSEN, Timothy, Westerville, 43082 (US); GILSON, Casey, Westerville, 43082 (US); THOMAS, Caleb, Westerville, 43082 (US)
(74) Representative: Ambroz, Simon

(57) **Abstract**

A power distribution unit may include an input power connector configured to receive input electrical power from an external power source. The power distribution unit may include a primary busbar configured to receive the input electrical power from the input power connector and distribute the input electrical power via a power configuration. The power distribution unit may include an output controller assembly configured to receive distributed input electrical power from the primary busbar and manage the distributed input electrical power. A power distribution unit may include a plurality of receptacles configured to receive the distributed input electrical power from the output controller assembly, wherein power to one or more of the plurality of receptacles is based on the power configuration.

## Description

### CROSS-REFERENCE TO RELATED APPLICATIONS

The present application claims the benefit under 35 U.S.C § 119(e) to U.S. Provisional Application No. 63/760,434, filed February 19, 2025, and U.S. Nonprovisional application 19/,533,951, filed February 9, 2026.

### TECHNICAL FIELD

The present disclosure relates generally to power distribution and, more particularly, to wiring strategies and designs in power distribution units.

### BACKGROUND

Physical volumes within rack power distribution unit (PDU) chassis are limited by geometry and mounting factors. Cable density (e.g., the number of low gauge wires per chassis) presents a significant design restriction for new product development. As power demands for PDUs continue to rise, higher copper-density requirements will follow. Cabling requirements for PDUs are one of the most limiting factors for product design. Therefore, there is a need for PDUs and PDU design strategies that are less limited to these cabling requirements.

### SUMMARY

In some examples, the systems described herein relate to a power distribution unit for powering electronic equipment, the power distribution unit including: an input power connector configured to receive input electrical power from an external power source; a primary busbar configured to receive the input electrical power from the input power connector and distribute the input electrical power via a power configuration; an output controller assembly configured receive distributed input electrical power from the primary busbar and manage the distributed input electrical power; and a plurality of receptacles configured to receive the distributed input electrical power from the output controller assembly, wherein power to one or more or the plurality of receptacles is based on the power configuration.

In some examples, the systems described herein relate to a power distribution unit, wherein the primary busbar includes: a phase input connector mounts configured to receive the input electrical power from the input power connector; a set of output select connector mounts electrically couplable to the phase input connector mounts and the output controller assembly; and a set of return select connector mounts couplable to the output controller assembly.

In some examples, the systems described herein relate to a power distribution unit, wherein the set of output select connector mounts is electrically coupled to the output controller assembly via fasteners.

In some examples, the systems described herein relate to a power distribution unit, wherein the set of return select connector mounts is electrically coupled to the output controller assembly via the fasteners.

In some examples, the systems described herein relate to a power distribution unit, wherein the primary busbar includes a printed circuit board (PCB).

In some examples, the systems described herein relate to a power distribution unit, wherein the primary busbar further includes phase output connector mounts configured to receive input power from the phase input connector mounts.

In some examples, the systems described herein relate to a power distribution unit, further including one or more secondary busbars electrically coupled to the primary busbar and configured to propagate power from the input power connector.

In some examples, the systems described herein relate to a power distribution unit, further including: another primary busbar; and a secondary busbar configured to electrically couple the primary busbar and another primary busbar.

In some examples, the systems described herein relate to a power distribution unit, wherein the primary busbar is configured to separately conduct phases of an alternating current.

In some examples, the systems described herein relate to a primary busbar for a power distribution unit, the primary busbar including: a phase input connector mounts configured to receive an input electrical power from the input power connector; a set of output select connector mounts electrically couplable to the phase input connector mounts and an output controller assembly; and a set of return select connector mounts couplable to the output controller assembly.

In some examples, the systems described herein relate to a power distribution unit, wherein the primary busbar is configured to separately conduct phases of an alternating current.

In some examples, the systems described herein relate to a primary busbar, wherein the primary busbar includes a printed circuit board (PCB).

In some examples, the techniques described herein relate to a method for assembling a power distribution unit, the method including: electrically coupling an output select connector mount of a primary busbar to a component layer of an output controller assembly via a fastener; and electrically coupling a return select connector mount of the primary busbar to the component layer of the output controller assembly via a fastener.

In some examples, the techniques described herein relate to a method, wherein the primary busbar includes a printed circuit board (PCB).

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF DRAWINGS

The numerous advantages of the disclosure may be better understood by those skilled in the art by reference to the accompanying figures.
FIG. 1 illustrates a block diagram of a power distribution unit (PDU), in accordance with one or more examples of the disclosure.
FIG. 2 illustrates a perspective view of a primary busbar of a PDU, in accordance with one or more examples of the disclosure.
FIG. 3 illustrates a perspective view of a primary busbar physically coupled to an outlet controller assembly, in accordance with one or more examples of the disclosure.
FIG. 4A illustrates a perspective view of a secondary busbar positioned next to the outlet controller assembly and primary busbar of FIG. 3, in accordance with one or more examples of the disclosure.
FIG. 4B illustrates a perspective view of a secondary busbar coupled to the outlet controller assembly and primary busbar of FIG. 3, in accordance with one or more examples of the disclosure.
FIG. 5 illustrates a process flow diagram depicting a method for assembling a power distribution unit, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art, having the benefit of the instant disclosure, that the examples disclosed herein may be practiced without some of these specific details. In other instances, well-known features may not be described in detail to avoid unnecessarily complicating the instant disclosure.

As used herein, a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein, any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Examples of the present disclosure are directed to a power distribution unit (PDU) for powering electronic equipment, such as computer server racks within a data center. The PDU includes an input power connector for receiving power (e.g., from an external source), an output controller assembly configured to control power flow, and a plurality of receptacles that are couplable to electronic equipment (e.g., servers). The PDU further includes a busbar, such as a printed circuit board (PCB)-based busbar, which receives input electrical power and distributes the input electrical power to the output controller assembly and further determines which receptacles are powered via fasteners acting as output select connectors and return select connectors that conduct the distributed input electrical power between the busbar and the output controller.

The ability of the primary busbar to selectively power receptacles via fasteners from the one or more sets of output select connectors and the sets of return select connectors results in a configuration (e.g., a power configuration) that simplifies wiring of the PDU. When the PDU receives input electrical power, the primary busbar distributes it according to the configuration, resulting in a distributed input that electrifies specific receptacles.

Examples of the present disclosure are particularly advantageous for intelligent or managed PDUs and PDU systems in which the receptacles are individually controlled. Such systems typically require internal cabling to connect each independent receptacle to the power source, which occupies space within the PDU. The busbar used in the disclosed PDU reduces the need for outlet-level cabling, thereby lowering assembly time, component costs, system complexity, and housing space requirements. For example, a PDU with six receptacles for powering server computers would require six sets of cables connecting the receptacles to power-control elements. The six cables would require considerable time during manufacture to connect the wires to the receptacles and control elements, and a housing large enough to store the wires. The busbar of the present disclosure allows multiple connections between the receptacles and the power control elements to be made simultaneously or near-simultaneously, while reducing the footprint of the PDU compared to traditional PDU designs. Reducing the PDU footprint may also benefit power systems that use PDUs by freeing space that could otherwise be used for other power, computing, or cooling subsystems.

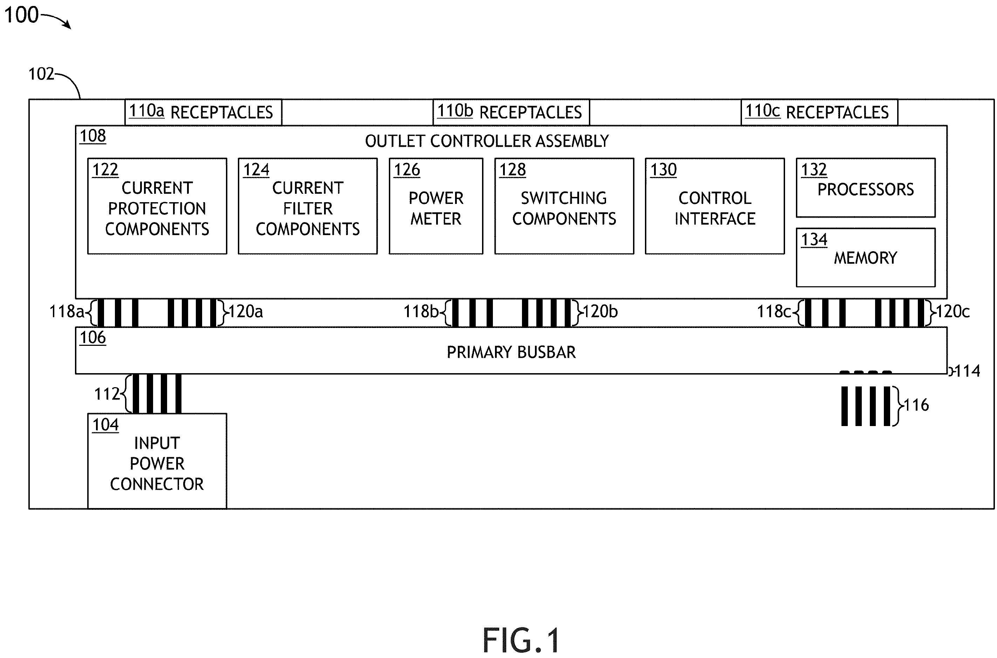

FIG. 1 is a diagram of a PDU 100, in accordance with one or more examples of the disclosure. The PDU 100 may be used for controlling power to electronic equipment, such as servers in a server rack.

In examples, the PDU 100 includes a housing 102 configured to house one or more components of the PDU 100. The housing 102 may be of any size or form. For example, the housing 102 may be sized and formed so that it can be integrated into a server rack.

In examples, the PDU 100 includes an input power connector 104 configured to receive power (e.g., an input electrical power) from an external power source, such as an alternating current (AC) power source (e.g., mains).

In examples, the PDU 100 includes one or more primary busbars 106 configured to receive power (e.g., an input power) from the input power connector 104 and distribute the power to a downstream component of the PDU 100, such as an outlet controller assembly 108 and/or receptacles 110a, 110b, 110c. The one or more primary busbars 106 may be made of any material or form for the conduction and transfer of power, including, but not limited to, printed circuit board (PCB) material. For example, the primary busbar 106 may include a single-sided PCB, a double-sided PCB, a multilayer PCB, a flexible PCB, a rigid-flex PCB, a high-density interconnect (HDI) PCB, an aluminum PCB, an FR4-containing PCB, a high Tg PCB, a metal core PCB, and/or a heavy copper PCB.

In examples, one or more sets of phase input connectors 112 are configured to direct power (e.g., three-phase AC power) from the input power connector 104 to the primary busbar 106. For example, a set of phase input connectors 112 includes three connectors (e.g., X, Y, Z) for receiving one phase of AC power, and a neutral connector (e.g., N). By having separate connectors and traces for AC power, the primary busbar 106 is configured to conduct the phases of alternating current separately.

In examples, the primary busbar 106 includes a set of phase output connector mounts 114 (e.g., holes) configured to receive phase output connectors 116. The set of phase output connector mounts 114 and the phase output connectors 116 may receive power directly from the phase input connectors 112 via traces within the primary busbar 106 (e.g., traces or other conducive paths within the PCB material). For example, the phase output connectors 116 may include three phase connectors (e.g., X, Y, Z) and/or a neutral connector (e.g., N), each electrically coupled to a respective connector from the phase input connectors 112. The set of phase output connectors 116 may be further coupled to one or more other primary busbars 106, secondary busbars, or other outlet paths, as described below.

In examples, the PDU 100 includes one or more sets of output select connectors 118a, 118b, 118c configured to direct power from the primary busbar 106 to the output controller assembly 108, and one or more of sets of return select connectors 120a, 120b, 120c configured to return power from the outlet controller assembly 108 to the primary busbar 106. For example, the one or more sets of output select connectors 118a, 118b, 118c and/or the one or more of sets of return select connectors 120a, 120b, 120c may include fasteners that conduct power between the primary busbar 106 and the output controller assembly 108, and may further secure the primary busbar 106 to the output controller assembly 108. The fasteners may include, but are not limited to, screws, bolts, pins, quick-connect fasteners, and quick pinch connectors. The fasteners may be formed of, or be plated with, electrically conductive material including, but not limited to, copper, iron, steel, aluminum, nickel, brass, zinc, and conductive carbon fiber. The fasteners may be threaded or unthreaded.

In examples, the primary busbar 106 is a passive electrical device. For example, the primary busbar 106 may include traces (e.g., conductive paths) that passively route electricity from the input power connector 104 to the outlet controller assembly 108 (e.g., without any active circuitry). In an alternative example, the primary busbar 106 may operate as an active component, routing electrical power at least in part based on processive circuitry integrated into the primary busbar 106.

In examples, the outlet controller assembly 108 manages power within the PDU 100. Power management functions may include, but are not limited to, controlling the flow of power from the primary busbar 106 to the receptacles 110a, 110b, and 110c; providing overcurrent protection; measuring power levels; reducing power noise; communicating power parameters; and altering power characteristics. For example, the output controller assembly 108 may include current protection components 122 that protect the PDU 100 and downstream electronic components from damage due to overcurrent. For instance, the current protection components 122 may include one or more breakers or fuses. In another example, the outlet controller assembly 108 may include current filter components 124, including, but not limited to, surge protection filters, electromagnetic interference (EMI) filters, radio frequency interference (RFI) filters, power factor correction (PFC) filters, and grounding filters. In another example, the outlet controller assembly 108 may include one or more power meters 126, including, but not limited to voltage meters, current meters, Watt meters, per-outlet power metering, power factor meters, temperature monitoring, and humidity monitoring.

In examples, the outlet controller assembly includes switching components 128. The switching components 128 may include switches, relays, and other componentry that enable, disable, or otherwise control power to specific receptacles 110a, 110b, 110c or groups of receptacles 110a, 110b, 110c. The switching components 128 may include componentry that allows remote control power to the specific receptacles 110a, 110b, 110c, such as over a network (e.g., a web interface and/or Simple Network Management Protocol (SNMP)). The switching components 128 may also manage the sequencing of power between the receptacles 110a, 110b, 110c.

In examples, the outlet controller assembly 108 includes a control interface 130 configured to control and/or display information (e.g., status information) of the PDU 100. For example, the control interface 130 may include one or more network interfaces (e.g., Ethernet interfaces, serial port interfaces) that enable remote communication, monitoring, and/or control. For instance, the control interface 130 may include network interfaces for datalogging, communicating alerts and notifications, and/or communicating power-control instructions (e.g., instructions to control power to one or more receptacles 110a, 110b, 110c). The control interface 130 may also include a human interface (e.g., display, buttons) that allows an operator to receive and enter PDU-related information.

In examples, the outlet controller assembly 108 may include one or more processors 132 and memory 134, the memory 134 configured to store instructions that are carried out (e.g., executed) by the one or more processors 132 for the outlet controller assembly 108 and/or one or more components of the outlet controller assembly 108. For example, one or more processors 132 may include control logic or otherwise be instructed by software stored in memory 134 to direct the distribution of power through the PDU 100. For instance, one or more processors 132 may balance load across different circuits, manage power redundancy, and/or ensure that specific devices or components receive priority power.

In example, the PDU 100 includes the one or more receptacles 110a, 110b, 110c (e.g., outlets) for powering downstream electronic components such as servers. The one or more receptacles 110a, 110b, 110c may be compatible with one or more power connector couplers, including, but not limited to, National Electrical Manufacturers Association (NEMA) power connectors, International Electrotechnical Commission (IEC) power connectors, and locking connectors (e.g., L6, L14, and L21).

In examples, power flowing through the one or more receptacles 110a, 110b, 110c is controlled by the flow of power through the respective sets of output select connectors 118a, 118b, 118c and sets of return select connectors 120a, 120b, 120c. For example, a first receptacle 110a of the PDU 100 may include a Line 1 (e.g., phase) side that receives power through a first set of output selector connectors 118a and a Line 2 (e.g., return or neutral) side that returns power through a first set of return connectors 120a. In another example, a second receptacle 110b of the PDU 100 may include a Line 1 side that receives power through a second set of output selector connectors 118b and a Line 2 side that returns power through a second set of return select connectors 120b.

In examples, the housing 102 is configured to house at least the input power connector, the primary busbar, and the plurality of receptacles 110a-c. In examples, the PDU 100 does not include cabling electrically coupled between the input power connector 104 and the output controller assembly 108. In other words, the primary busbar 106 replaces cabling between the input power connector 104 and the outlet controller assembly 108.

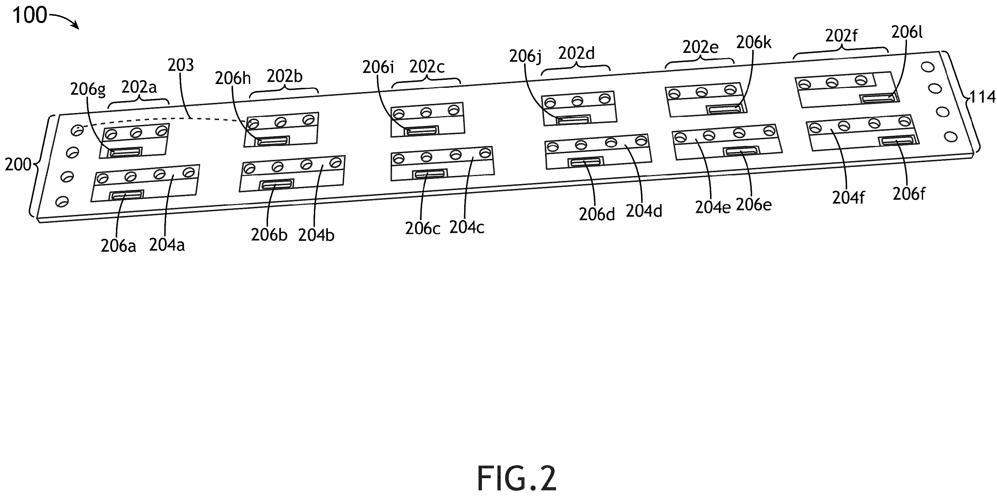

FIG. 2 illustrates a perspective view of the primary busbar 106, in accordance with one or more examples of the disclosure. The primary busbar 106 may include a set of phase input connector mounts 200 configured to receive a set of phase input connectors 112. The primary busbar 106 may include the phase output connector mounts 114 configured to receive the phase output connectors 116.

In examples, the primary busbar 106 includes one or more sets of output select connector mounts 202a-f configured to receive respective sets of output select connectors 118a-c (e.g., for powering respective receptacles 110a-110f via the outlet controller assembly 108). For example, each set of output select connector mounts 202a-f may have mounts for each phase (e.g., X, Y, and Z), that may be electrically coupled to the set of phase input connector mounts 200.

In examples, the primary busbar 106 includes one or more sets of return select connector mounts 204a-f configured to receive respective sets of return select connectors 120a-c (e.g., for receiving return power from respective receptacles 110a-110f via the outlet controller assembly 108). For example, each set of return select connector mounts 204a-f may have mounts for each phase and neutral (e.g., X, Y, Z, and N) that may be electrically coupled to the set of the phase output connector mounts 114 and/or a phase input connector mounts 200.

In examples, the primary busbar may utilize one or more traces 203 or sets of traces 203 to control the transfer of electricity across the primary busbar. For example, the primary busbar 106 may include conductive traces 203 that electrically couple the phase input connector mounts 200 to the output select connector mounts 202a-f. In another example, the primary busbar 106 may include conductive traces 203 that electrically couple the return select connector mounts 204a-f to the phase output connector mounts 114, and/or the neutral (e.g., N) mount of the phase input connector mounts 200, as described herein. In another example, the primary busbar 106 may also include traces 203 that electrically couple the phase input connector mounts 200 directly or indirectly to the phase output connector mounts 114.

In examples, the primary busbar 106 is physically coupled to the outlet controller assembly 108 via one or more attachment mounts 206a-l (e.g., solder mounts). The attachment mounts 206a-l may include other types of attachment technology including, but not limited to, pins, screws, bolts, clips, terminals, and clamps. In an alternative example, one or more of the attachment mounts 206a-l provides power to and/or from the outlet controller assembly 108.

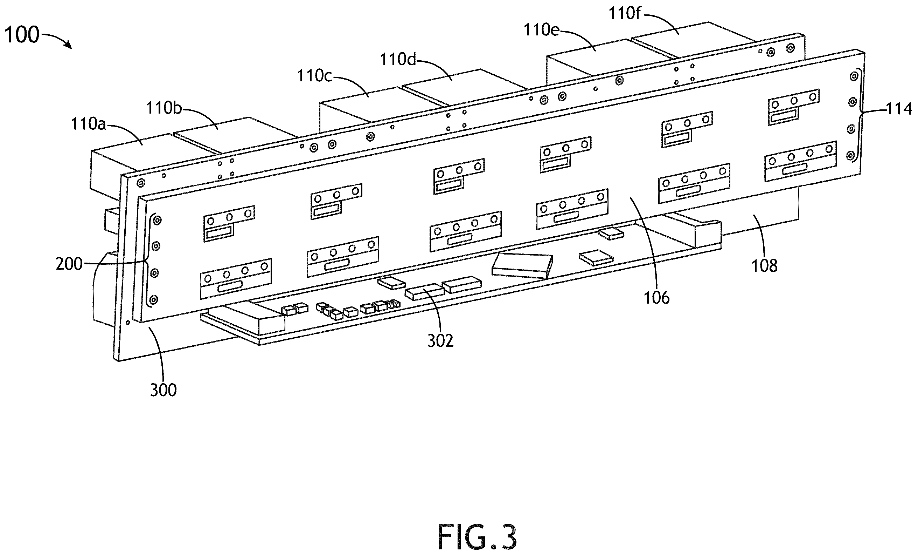

FIG. 3 illustrates a perspective view of a primary busbar 106 physically coupled to the outlet controller assembly 108 (e.g., via attachment mounts 206a-l) having six receptacles 110a-110f, in accordance with one or more examples of the disclosure. The outlet controller assembly 108 may include a component layer 300 (e.g., a PCB) that interfaces with the primary busbar 106. For example, the component layer 300 may be configured to receive the fasteners from the primary busbar (e.g., from the sets of output select connectors 118a-f and/or the sets of return select connectors 120a, 120b, 120c) which electrically couple (e.g., in addition to mechanically coupling) the primary busbar 106 to the component layer 300. The outlet controller assembly 108 may further include a component area 302 electrically coupled to the component layer 300, which contains many of the components (e.g., processors 132) required to control the flow of power to the receptacles. Together, the component layer 300 and the component area 302 provide the necessary circuitry to manage the power supplied to each receptacle 110a from its corresponding set of output select connector mounts 202a.

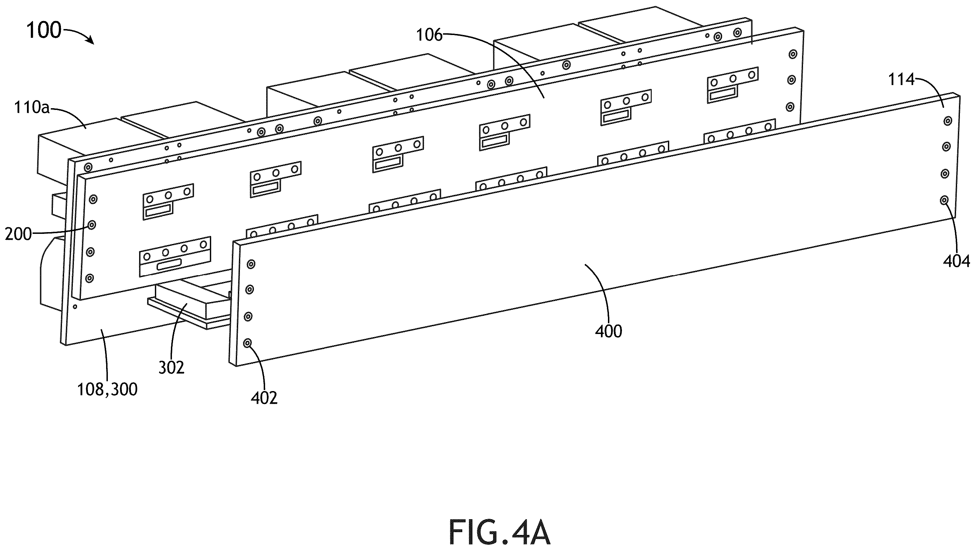

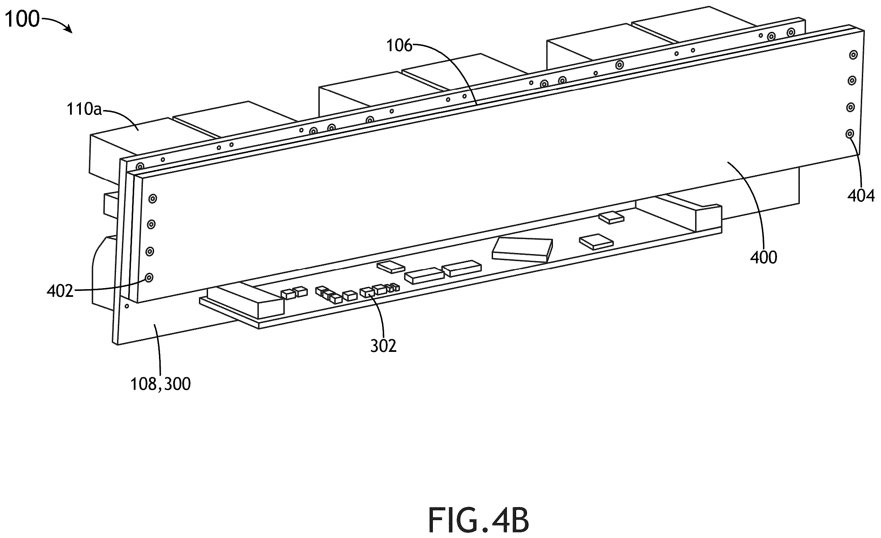

FIG. 4A and 4B illustrate perspective views of a secondary busbar 400 positioned next to and coupled to, the primary busbar 106, respectively, in accordance with one or more examples of the disclosure. The secondary busbar 400 may include a layer (e.g., a PCB layer) that includes a set of phase input connectors mounts 402 (e.g., for tying in with the phase input connector mounts 200 of the primary busbar 106) and a set of phase output connector mounts 404 (e.g., for tying in with the phase output connector mounts 114 of the primary busbar 106. The secondary busbar 400 may conduct electrical power along traces in the secondary busbar 400 from the set of phase input connectors mounts 402 to the set of phase output connector mounts 404. For example, for systems wherein the primary busbar 106 is not able to handle the amount of electrical power supplied by the PDU 100, one or more secondary busbars 400 may be used (e.g., stacked) in order to safely provide power to the outlet controller assembly 108. For example, multiple secondary busbars 400 (e.g., from two or more to six or more) may be stacked on the primary busbar 106, enabling the PDU 100 to support higher power loads (e.g., by allowing the primary busbar to provide power flow through the PDU).

In examples, the secondary busbar 400 may include, or may not include, selectable connectivity. For example, the secondary busbar 400 may include sets of output select connector mounts 202a-f and sets of return select connector mounts 204a-f, similar to that of the primary busbar 106 (e.g., a selectable output bussing busbar). In another example, the secondary busbar 400 may be used only for bussing power through the PDU body, and therefore does not have sets of output select connector mounts 202a-f and sets of return select connector mounts 204a-f. Upon coupling of the secondary busbar 400 to the PDU 100, the primary busbar 106 may be partially hidden, as shown in FIG. 4B.

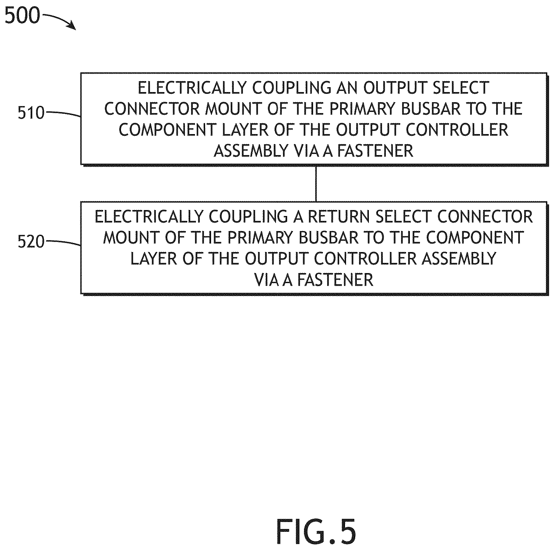

FIG. 5 illustrates a process flow diagram depicting a method 500 for assembling a power distribution unit, in accordance with one or more examples of the disclosure. The method 500 may be used for assembling the PDU 100 as described in this disclosure.

In examples, the method 500 includes a step 510 of electrically coupling an output select connector mount 202a-f of the primary busbar 106 to the component layer 300 of the output controller assembly 108 via a fastener. For example, for each phase of an AC current, an output select connector mount 202a-f may be coupled to a respective connection on a component layer 300 of the PDU 100via a screw, a pin, or other type of fastener.

In examples, the method 500 includes a step 520 of electrically coupling a return select connector mount 204a-f of the primary busbar 106 to the component layer 300 of the output controller assembly 108 via a fastener. For example, for each phase of an AC current, a return select connector mount 204a-f may be coupled to a respective connection on a component layer 300 of the PDU 100 via a screw, a pin, or other type of fastener.

The ability of the primary busbar 106 to selectively power receptacles via fasteners from the one or more sets of output select connectors 118a, 118b, 118c and the sets of return select connectors 120a, 120b, 120c results in a configuration (e.g., a power configuration) that simplifies wiring of the PDU. When the PDU 100 receives input electrical power, the primary busbar 106 distributes the power based on the configuration, resulting in a distributed input electrical power that electrifies specific receptacles 110a-f based on the configuration. The primary busbar removes the need for output-level cabling, reducing assembly time, component cost, and system complexity. For example, by implementing the primary busbar 106, six or more wire connectors may be removed from previous PDU designs. For instance, the number of wire connectors removed from a previous PDU design may include twelve or more, may include 24 or more connectors, many include 36 or more connectors, may include 48 or more connectors, or may include 54 or more connectors.

As described above, the primary busbar 106 conducts all three AC phases within its layered body, with fasteners used to select the outlet phase and return path (e.g., phase or neutral). The primary busbar 106 and secondary busbar 400 are stackable for higher current throughput. The PDU 100 may have any number of receptacles 110a-f, any number of primary busbars 106, and any number of secondary busbars.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and/or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein, which can be implemented, individually and/or collectively, by a wide range of hardware, software, firmware, or any combination thereof, can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application-specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein. It is to be understood that the invention is defined by the appended claims.

Disclosed herein are also the following clauses:
1. A power distribution unit for powering electronic equipment, the power distribution unit comprising: an input power connector configured to receive input electrical power from an external power source; a primary busbar configured to receive the input electrical power from the input power connector and distribute the input electrical power via a power configuration; an output controller assembly configured to receive distributed input electrical power from the primary busbar and manage the distributed input electrical power; and a plurality of receptacles configured to receive the distributed input electrical power from the output controller assembly, wherein power to one or more of the plurality of receptacles is based on the power configuration.
2. The power distribution unit of clause 1, wherein the primary busbar comprises: a phase input connector mount configured to receive the input electrical power from the input power connector; a set of output select connector mounts electrically couplable to the phase input connector mount and the output controller assembly; and a set of return select connector mounts couplable to the output controller assembly.
3. The power distribution unit of clause 2, wherein the set of output select connector mounts is electrically coupled to the output controller assembly via fasteners.
4. The power distribution unit of clause 3, wherein the set of return select connector mounts is electrically coupled to the output controller assembly via the fasteners.
5. The power distribution unit of clause 2, wherein the primary busbar comprises a printed circuit board (PCB).
6. The primary busbar of clause 5, wherein the phase input connector mount is electrically coupled to at least one output select connector mount of the set of output select connector mounts via a trace.
7. The power distribution unit of clause 1, wherein the primary busbar further comprises phase output connector mounts configured to receive input power from the phase input connector mounts.
8. The power distribution unit of clause 1, further comprising one or more secondary busbars electrically coupled to the primary busbar and configured to support a flow of power through the power distribution unit.
9. The power distribution unit of clause 1, further comprising: another primary busbar; and a secondary busbar configured to electrically couple the primary busbar and the another primary busbar.
10. The power distribution unit of clause 1, wherein the primary busbar is configured to separately conduct phases of an alternating current.
11. The power distribution unit of clause 1, comprising a housing configured to house the input power connector, the primary busbar, and the plurality of receptacles.
12. The power distribution of clause 11, wherein the power distribution unit does not include cabling electrically coupled between the input power connector and the output controller assembly.
13. A primary busbar for a power distribution unit, the primary busbar comprising: a phase input connector mount configured to receive an input electrical power from an input power connector of the power distribution unit; a set of output select connector mounts electrically couplable to the phase input connector mounts and an output controller assembly of the power distribution unit, wherein the set of output select connector mounts is configured to distribute the input electrical power; and a set of return select connector mounts couplable to an output controller assembly of the power distribution unit.
14. The primary busbar of clause 13, wherein the primary busbar is configured to separately conduct phases of an alternating current.
15. The primary busbar of clause 13, wherein the primary busbar comprises a printed circuit board (PCB).
16. The primary busbar of clause 15, wherein the phase input connector mount is electrically coupled to at least one output select connector mount of the set of output select connector mounts via a trace.
17. The primary busbar of clause 13, wherein the set of output select connector mounts is electrically coupled with the output controller assembly via fasteners.
18. The primary busbar of clause 17, wherein the set of return select connector mounts is electrically coupled to the output controller assembly via the fasteners.
19. A method for assembling a power distribution unit, the method comprising: electrically coupling an output select connector mount of a primary busbar to a component layer of an output controller assembly via a fastener; and electrically coupling a return select connector mount of the primary busbar to the component layer of the output controller assembly via a fastener.
20. The method of clause 19, wherein the primary busbar comprises a printed circuit board (PCB).

Described herein is also a method for assembling a power distribution unit according to any one of the clauses 1 to 12, the method comprising: electrically coupling an output select connector mount of a primary busbar to a component layer of an output controller assembly via a fastener; and electrically coupling a return select connector mount of the primary busbar to the component layer of the output controller assembly via a fastener.

Described herein is also a primary busbar for a power distribution unit of any one of the clauses 1 to 12.

Described herein is also a power distribution unit comprising the primary busbar of any one of the clauses 13 to 18.

## Claims

1. A power distribution unit for powering electronic equipment, the power distribution unit comprising:
an input power connector configured to receive input electrical power from an external power source;
a primary busbar configured to receive the input electrical power from the input power connector and distribute the input electrical power via a power configuration;
an output controller assembly configured to receive distributed input electrical power from the primary busbar and manage the distributed input electrical power; and
a plurality of receptacles configured to receive the distributed input electrical power from the output controller assembly, wherein power to one or more of the plurality of receptacles is based on the power configuration.

2. The power distribution unit of claim 1, wherein the primary busbar comprises:
a phase input connector mount configured to receive the input electrical power from the input power connector;
a set of output select connector mounts electrically couplable to the phase input connector mount and the output controller assembly; and
a set of return select connector mounts couplable to the output controller assembly.

3. The power distribution unit of claim 2, wherein the set of output select connector mounts is electrically coupled to the output controller assembly via fasteners.

4. The power distribution unit of any one of the claims 2 to 3, wherein the set of return select connector mounts is electrically coupled to the output controller assembly via the fasteners.

5. The power distribution unit of any one of the claims 2 to 4, wherein the primary busbar comprises a printed circuit board (PCB).

6. The primary busbar of claim 5, wherein the phase input connector mount is electrically coupled to at least one output select connector mount of the set of output select connector mounts via a trace.

7. The power distribution unit of any one of the preceding claims, wherein the primary busbar further comprises phase output connector mounts configured to receive input power from the phase input connector mounts.

8. The power distribution unit of any one of the preceding claims, further comprising one or more secondary busbars electrically coupled to the primary busbar and configured to support a flow of power through the power distribution unit.

9. The power distribution unit of any one of the preceding claims, further comprising:
another primary busbar; and
a secondary busbar configured to electrically couple the primary busbar and the another primary busbar.

10. The power distribution unit of any one of the preceding claims, wherein the primary busbar is configured to separately conduct phases of an alternating current.

11. The power distribution unit of any one of the preceding claims, comprising a housing configured to house the input power connector, the primary busbar, and the plurality of receptacles.

12. The power distribution of claim 11, wherein the power distribution unit does not include cabling electrically coupled between the input power connector and the output controller assembly.

13. A primary busbar for a power distribution unit, the primary busbar comprising:
a phase input connector mount configured to receive an input electrical power from an input power connector of the power distribution unit;
a set of output select connector mounts electrically couplable to the phase input connector mounts and an output controller assembly of the power distribution unit, wherein the set of output select connector mounts is configured to distribute the input electrical power; and
a set of return select connector mounts couplable to an output controller assembly of the power distribution unit.

14. The primary busbar of claim 13, wherein the primary busbar is configured to separately conduct phases of an alternating current;
or optionally wherein the primary busbar comprises a printed circuit board (PCB) and wherein the phase input connector mount is electrically coupled to at least one output select connector mount of the set of output select connector mounts via a trace;
and optionally wherein the set of output select connector mounts is electrically coupled with the output controller assembly via fasteners and wherein the set of return select connector mounts is electrically coupled to the output controller assembly via the fasteners.

15. A method for assembling a power distribution unit, the method comprising: electrically coupling an output select connector mount of a primary busbar to a component layer of an output controller assembly via a fastener;
and electrically coupling a return select connector mount of the primary busbar to the component layer of the output controller assembly via a fastener.

## Amended claims

### Amended claims in accordance with Rule 137(2) EPC.

1. A power distribution unit (100) for powering electronic equipment, the power distribution unit (100) comprising:
an input power connector (104) configured to receive input electrical power from an external power source;
a primary busbar (106) configured to receive the input electrical power from the input power connector (104) and distribute the input electrical power via a power configuration;
an output controller assembly (108) configured to receive distributed input electrical power from the primary busbar (106) and manage the distributed input electrical power; and
a plurality of receptacles (110a-f) configured to receive the distributed input electrical power from the output controller assembly (108), wherein power to one or more of the plurality of receptacles (110a-f) is based on the power configuration;
wherein the primary busbar (106) is made of a printed circuit board material which includes at least one trace that routes the input electrical power from the input power connector (104) to the output controller assembly (108).

2. The power distribution unit (100) of claim 1, wherein the primary busbar (106) comprises:
a phase input connector mount (200) configured to receive the input electrical power from the input power connector (104);
a set of output select connector mounts (202a-f) electrically couplable to the phase input connector mount (200) and the output controller assembly (108); and
a set of return select connector mounts (204a-f) couplable to the output controller assembly (108).

3. The power distribution unit (100) of claim 2, wherein the set of output select connector mounts (202a-f) is electrically coupled to the output controller assembly (108) via fasteners.

4. The power distribution unit (100) of any one of the claims 2 to 3, wherein the set of return select connector mounts (204a-f) is electrically coupled to the output controller assembly (108) via the fasteners.

5. The power distribution unit (100) of claim 1, wherein the phase input connector mount (200) is electrically coupled to at least one output select connector mount (202a-f) of the set of output select connector mounts (202a-f) via the at least one trace (203).

6. The power distribution unit (100) of any one of the preceding claims, wherein the primary busbar (106) further comprises phase output connector mounts (114) configured to receive input power from the phase input connector mounts (200).

7. The power distribution unit (100) of any one of the preceding claims, further comprising one or more secondary busbars (400) electrically coupled to the primary busbar (106) and configured to support a flow of power through the power distribution unit (100).

8. The power distribution unit (100) of any one of the preceding claims, further comprising:
another primary busbar; and
a secondary busbar (400) configured to electrically couple the primary busbar (106) and the another primary busbar.

9. The power distribution unit (100) of any one of the preceding claims, wherein the primary busbar (106) is configured to separately conduct phases of an alternating current.

10. The power distribution unit (100) of any one of the preceding claims, comprising a housing (102) configured to house the input power connector (104), the primary busbar (106), and the plurality of receptacles (110a-f).

11. The power distribution unit of claim 10, wherein the power distribution unit (100) does not include cabling electrically coupled between the input power connector (104) and the output controller assembly (108).

12. A primary busbar (106) for a power distribution unit (100), the primary busbar (106) comprising:
a phase input connector mount (200) configured to receive an input electrical power from an input power connector (104) of the power distribution unit (100);
a set of output select connector mounts (202a-f) electrically couplable to the phase input connector mounts (200) and an output controller assembly (108) of the power distribution unit (100), wherein the set of output select connector mounts (202a-f) is configured to distribute the input electrical power; and
a set of return select connector mounts (204a-f) couplable to an output controller assembly (108) of the power distribution unit (100);
wherein the primary busbar (106) is made of a printed circuit board material which includes at least one trace that routes the input electrical power from the input power connector (104) to the output controller assembly (108).

13. The primary busbar (106) of claim 12, wherein the primary busbar (106) is configured to separately conduct phases of an alternating current;
and wherein the phase input connector mount (200) is electrically coupled to at least one output select connector mount (202a-f) of the set of output select connector mounts (202a-f) via the at least one trace (203);
and optionally wherein the set of output select connector mounts (202a-f) is electrically coupled with the output controller assembly (108) via fasteners and wherein the set of return select connector mounts (204a-f) is electrically coupled to the output controller assembly (108) via the fasteners.

14. A method (500) for assembling a power distribution unit (100) according to any one of claims 1 to 11, the method (500) comprising: electrically coupling an output select connector mount (202a-f) of the primary busbar (106) to a component layer (300) of the output controller assembly (108) via a fastener;
and electrically coupling a return select connector mount (204a-f) of the primary busbar (106) to the component layer (300) of the output controller assembly (108) via a fastener.
